# EUROPEAN PATENT APPLICATION

(11) **EP 1 829 641 A1**
(43) Date of publication of application: **05.09.2007**
(21) Application number: 07004162.9
(22) Date of filing: 28.02.2007
(51) Int. Cl.: B23Q 1/48, G01R 31/28

(54) **Apparatus for, and method of, positioning an interface unit of an automatic test system**

(30) Priority: 01.03.2006 US 366773
(71) Applicant: Verigy (Singapore) Pte. Ltd., Singapore 768923 (SG)
(72) Inventor: Sprague, William T., Fort Collins CO 80525 (US); Chiu, Don, Fort Collins CO 80525 (US); Lobacz, Jerzy, Fort Collins CO 80525 (US); Karklin, Kenneth D., Fort Collins CO 80525 (US)
(74) Representative: Schoppe, Fritz

(57) **Abstract**

There is disclosed a manipulator (100) for positioning an interface of an automatic test system (104). In an embodiment, the manipulator (100) includes a support device (106) to support the interface. A base portion (108) is in connection to the support device (106). The base portion (108) includes a rotational adjustment mechanism (110) for moving the support device (106) about an axis (112) of rotation. A planar adjustment mechanism (114) moves the support device (106) within a plane (116) orthogonal to the axis (112) of rotation. There is disclosed a method of positioning an interface unit (102) of an automatic test system (104). In an embodiment, the method includes moving a support device (106) supporting the interface unit (102) a distance from a docking region of a material handling device (132); and rotating the support device (106) about an axis (112) of rotation passing through the interface unit (102). Other embodiments are also disclosed.

## Description

### Background

Generally, semiconductor devices may need to be tested during a manufacturing process. Automatic Test Equipment (ATE) may be used for testing. A tester may contain the circuitry to generate and measure the electrical signals, which are needed to determine if the device is functioning properly. A separate material handling device may be used to move the semiconductor devices to the tester.

A material handling device is often referred to as a handler when the semiconductor devices are being tested after they have been packaged. A material handling device is often referred to as a prober when the semiconductor devices are tested while still on a wafer.

In general, a tester and a material handling device are assembled into a test cell, with the specific characteristics of the tester and material handling device being selected based on the type of devices being tested.

Different interface units may be used to allow a tester to make connections with many different types of devices. Typically, the interface unit has probes or contacts. The material handling device may position the semiconductor devices being tested against the probes or contacts so as to allow electrical signals to move between the devices under test and the tester.

The interface may be located between the tester and the handler. The tester is usually moved to access the interface. Most interfaces are mounted on a device called a manipulator, which allows access to the interface. The manipulator may align the tester with the handler.

### Summary of the Invention

In one embodiment, there is provided manipulator for positioning an interface unit of an automatic test system, the manipulator comprising a support device to support the interface unit in removable attachment thereto; and a base portion in connection to the support device, the base portion comprising a rotational adjustment mechanism for moving the support device together with the interface unit about an axis of rotation; and a planar adjustment mechanism for moving the support device together with the interface unit within a plane orthogonal to the axis of rotation.

In another embodiment, there is provided a retrofit manipulator for positioning an interface unit of an automatic test system, the retrofit manipulator comprising a support device having the interface unit in removable attachment thereto; and a base portion in connection to the support device, the base portion comprising a rotational adjustment mechanism for moving the support device together with the interface unit about an axis of rotation; and an auxiliary adjustment mechanism for attachment to a drawer slide between a material handling device and a tester of the automatic test system, wherein the auxiliary adjustment mechanism and the existing drawer slide allow movement of the support device together with the interface unit within a plane orthogonal to the axis of rotation.

In yet another embodiment, there is provided an automatic test system, comprising a tester for generating and measuring electrical signals to determine whether semiconductor devices are functioning properly; a material handling device for presenting the semiconductor devices to the tester; and a manipulator for positioning an interface unit, the manipulator having a support device having the interface unit in removable attachment thereto, and a base portion in connection to the support device, the base portion having a rotational adjustment mechanism for moving the support device together with the interface unit about an axis of rotation, and the base portion having a planar adjustment mechanism for moving the support device together with the interface unit within a plane orthogonal to the axis of rotation.

In still another embodiment, there is provided a method of positioning an interface unit of an automatic test system, the method comprising moving a support device supporting the interface unit a distance from a docking region of a material handling device; and rotating the support device about an axis of rotation passing through the interface unit, wherein rotating the support device positions a longitudinal axis of the interface unit substantially orthogonal to the docking region of the material handling device.

Other embodiments are also disclosed.

### Brief Description of the Drawings

Illustrative embodiments of the invention are illustrated in the drawings, in which:

FIGURE 1 is an elevational view of a manipulator for positioning an interface unit of an automatic test system;

FIGURE 2 is a planar view of the manipulator shown in FIGURE 1;

FIGURE 3 illustrates an automatic test system with the manipulator as shown in FIGURE 1;

FIGURE 4 illustrates another view of the automatic test system and manipulator shown in FIGURE 3;

FIGURE 5 illustrates a gantry for use with the automatic test system of FIGURES 1-4; and

FIGURES 6 and 7 illustrate various method of positioning an interface unit of an automatic test system.

### Detailed Description of an Embodiment

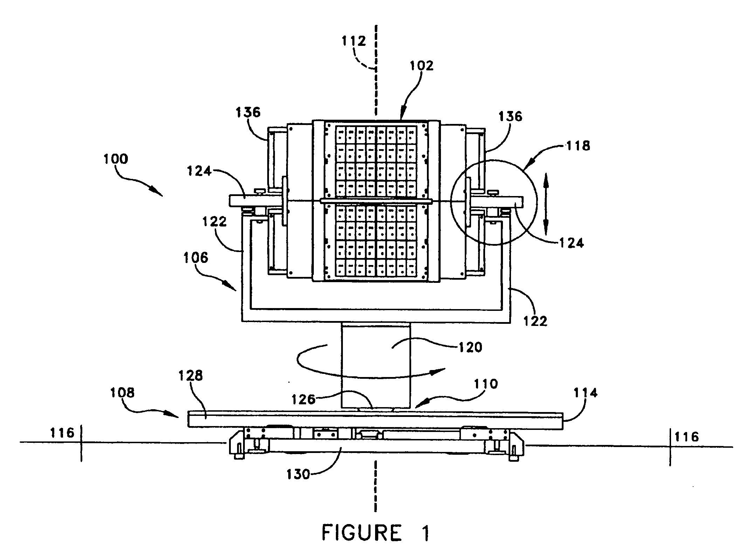

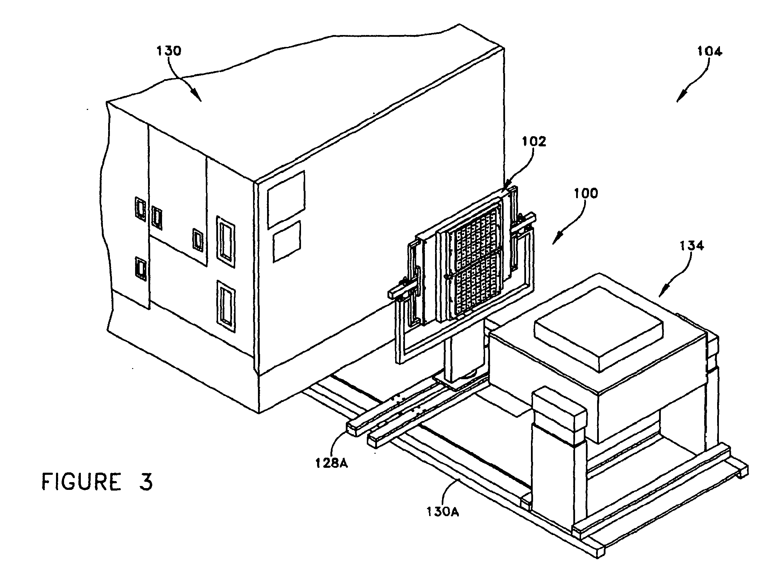

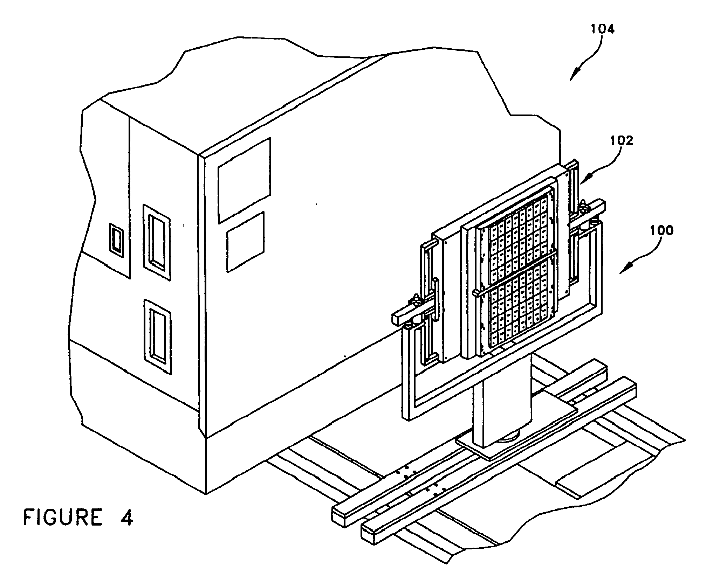

Referring to FIGURES 1-4, there is shown a manipulator 100 for positioning an interface unit 102 of an automatic test system 104 (FIGURES 3 and 4). ln an embodiment, manipulator 100 may include a support device 106 and a base portion 108. Support device 106 has interface unit 102 in removable attachment thereto. Base portion 108 is in connection to support device 106.

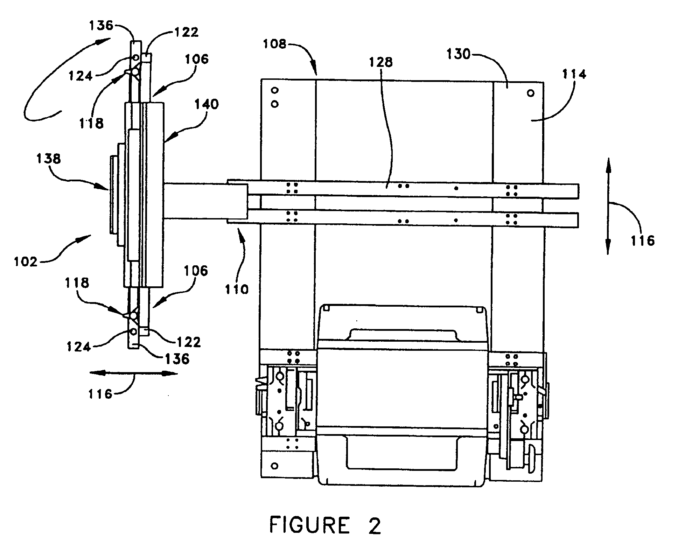

Looking at FIGURES 1 and 2, and in one embodiment, base portion 108 may include a rotational adjustment mechanism 110 for moving support device 106 together with interface unit 102 about an axis 112 of rotation. Base portion 108 may include a planar adjustment mechanism 114 for moving support device 106 together with interface unit 102 within a plane 116 orthogonal to axis 112 of rotation.

Referring still to FIGURES 1 and 2, and in an embodiment, there is shown an interface adjustment mechanism 118 for selectively adjusting the orientation between interface unit 102 and base portion 108. Interface adjustment mechanism 118 may be disposed on interface unit 102 and connect to support device 106.

In an embodiment, support device 106 may include a center post 120. Support device may include center post 120 in connection to base portion 108. A pair of arms 122 may extend from center post 120. Attachment portions 124 may be disposed on pair of arms 122. Attachment portions 124 may be configured to secure interface unit 102 in removable attachment to support device 106.

Referring to FIGURE 1, and in one embodiment, support device 106 and base portion 108 may be held in connection to one another by rotational adjustment mechanism 110. For example, rotational adjustment mechanism 110 may be a swivel mount 126. In another embodiment, rotational adjustment mechanism 110 may be a swivel 126 for moving support device 106 together with interface unit 102 about an axis 112 of rotation. Swivel 126 may include, but is not limited to, a link, pivot, or other fastening device so designed to permits the free turning of attached parts. Rotational adjustment mechanism 110 may include a pivoted support that allows support device 106 to turn in a horizontal plane. Rotational adjustment mechanism 110 may also include a lazy susan turnable device for allow rotation of the support device 106.

Looking at FIGURES 1-4, and in an embodiment, planar adjustment mechanism 114 may include a pair of drawer slides 128 and 130. Generally, the pair of drawer slides 128 and 130 may be positioned orthogonally with respect to one another.

In another embodiment, planar adjustment mechanism 114 includes an auxiliary drawer slide 128A positioned orthogonally with respect to an existing drawer slide 130A between a material handling device 132 and a tester 134. Support device 100 may include center post 120. Base portion 108 may include drawer slide 128A.

Looking at FIGURES 1-4, and in one embodiment, base portion 108 may include a pair of drawer slides 128 and 130 for moving support device 106 together with interface unit 102 within plane 116 orthogonal to axis 112 of rotation. The pair of drawer slides 128 and 130 may be positioned orthogonally with respect to one another.

Referring to FIGURES 1-4, and in an embodiment, manipulator 100 may be a retrofit manipulator for positioning interface unit 102 of automatic test system 104. Retrofit manipulator 100 may include support device 106 and base portion 108. Base portion 106 may include auxiliary adjustment mechanism 128A for attachment to drawer slide 130A between material handling device 132 and tester 134 of automatic test system 104. Auxiliary adjustment mechanism 128A and existing drawer slide 130A may allow movement of support device 106 together with interface unit 102 within plane 116 orthogonal to axis 112 of rotation.

Referring to FIGURES 1-4, automatic test system 104 may include a tester 134, a material handling device 132, interface unit 102, and manipulator 100. Generally, automatic test system 104 may be configured for generating and measuring electrical signals to determine whether semiconductor devices are functioning properly. Material handling device 132 may be configured for presenting semiconductor devices to tester 134. Interface unit generally has contacts for electrically connecting the semiconductor devices on material handling device 132 with tester 134.

In one embodiment, material handling device 132 may be a handler for packaged semiconductor devices. In another embodiment, material handling device 132 may be a prober for unpackaged semiconductor devices on a wafer.

Manipulator 100 may be an integral component of material handling device 132. Manipulator 100 may be an integral component of tester 134. Alternatively, manipulator 100 may be a discrete component, which is detached from material handling device 132.

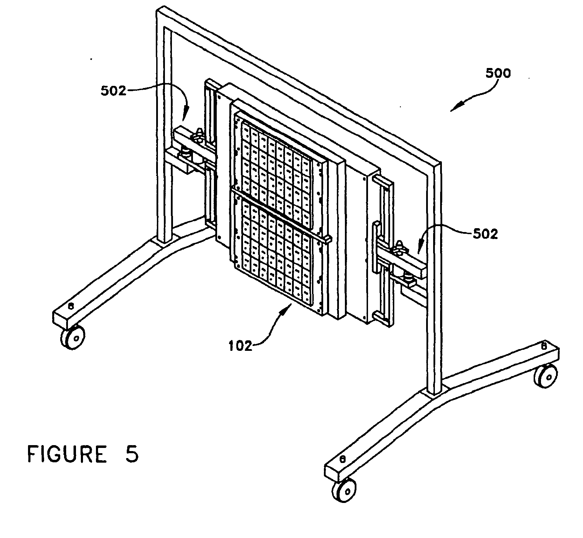

Looking at FIGURE 5, and in an embodiment, automatic test system 104 may include a gantry 500 for selectively lifting and lowering interface unit 102 from manipulator 100. Gantry 500 may have a pair of attachment locations 502 for connection with attachment portions 124 of interface unit 102. Gantry 500 may be positioned adjacent to interface unit 102 in manipulator 100 with support device 106 rotated to expose opposed sides 136 of interface unit. Typically, support device 106 is rotated about 90 degrees from the general operation location of tester 134.

Even without the use of gantry 500, translation and rotation of manipulator 100 allows rapid access to a front portion 138 and a rear portion 140 of interface unit 102. Furthermore, manipulator 100 provides access to both of opposed sides 136 of interface unit 102. This configuration may allow two people to lift at opposed sides 136 without interference from manipulator 100.

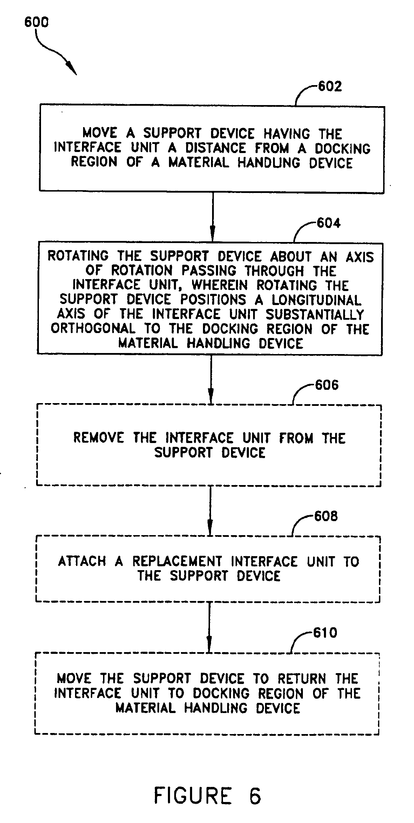

Looking at FIGURE 6, there is shown a method 600 of positioning an interface unit of an automatic test system. In an embodiment, method 600 may include moving 602 a support device supporting the interface unit a distance from a docking region of a material handling device. Method 600 may include rotating 1104 the support device about an axis of rotation passing through the interface unit, wherein rotating the support device positions a longitudinal axis of the interface unit substantially orthogonal to the docking region of the material handling device.

Optionally, method 600 may further include removing 606 the interface unit from the support device. In one embodiment, the step of removing 606 the interface may comprise lifting the interface unit with a gantry. In another embodiment, the step of removing 606 the interface may comprise lifting the interface unit by a worker, or by a pair of workers.

Optionally, method 600 may further include attaching 608 a replacement interface unit to the support device. Method 600 may also further include moving 610 the support device to return the interface unit to docking region of the material handling device.

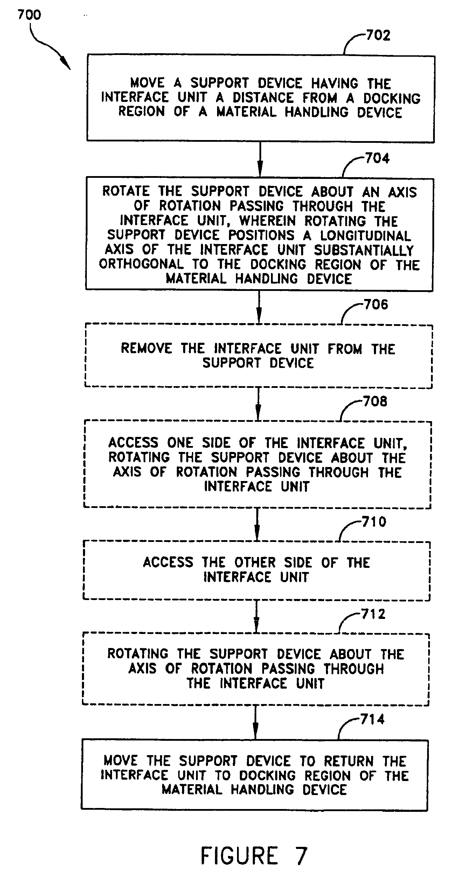

Referring now to FIGURE 7, there is shown a method 700 of positioning an interface unit of an automatic test system. In an embodiment, method 700 may include moving 702 a support device supporting the interface unit a distance from a docking region of a material handling device. Method 700 may include rotating 704 the support device about an axis of rotation passing through the interface unit. In one embodiment, rotating the support device positions a longitudinal axis of the interface unit substantially orthogonal to the docking region of the material handling device.

Optionally, method 700 may further include removing 706 the interface unit from the support device.

Optionally, and either in addition to, or alternatively of, the step of removing 706 the interface unit from the support device, method 700 may include accessing 708 one side of the interface unit, and rotating the support device about the axis of rotation passing through the interface unit. Method 700 may include accessing 712 the other side of the interface unit. Method 700 may include rotating 712 the support device about the axis of rotation passing through the interface unit.

Furthermore, method 700 may include moving 714 the support device to return the interface unit to docking region of the material handling device.

## Claims

1. A manipulator (100) for positioning an interface unit (102) of an automatic test system (104), the manipulator (100) comprising:
a support device (106) to support the interface unit (102) in removable attachment thereto; and
a base portion (108) in connection to the support device (106), the base portion (108) comprising:
a rotational adjustment mechanism (110) for moving the support device (106) together with the interface unit (102) about an axis (112) of rotation; and
a planar adjustment mechanism (114) for moving the support device (106) together with the interface unit (102) within a plane (116) orthogonal to the axis (112) of rotation.

2. A manipulator (100) in accordance with claim 1, wherein the support device (106) and the base portion (108) are in connection to one another by the rotational adjustment mechanism (110).

3. A manipulator (100) in accordance with claim 1, further comprising an automatic test system (104), comprising:
a tester (134) for generating and measuring electrical signals to determine whether semiconductor devices are functioning properly; and
a material handling device (132) for presenting the semiconductor devices to the tester (134).

4. An automatic test system (104) in accordance with claim 12, further comprising a gantry (500) for selectively lifting and lowering the interface unit (102) from the manipulator (100).

5. A method (600, 700) of positioning an interface unit of an automatic test system, the method comprising:
moving (602, 702) a support device supporting the interface unit a distance from a docking region of a material handling device; and
rotating (604, 704) the support device about an axis of rotation passing through the interface unit, wherein rotating the support device positions a longitudinal axis of the interface unit substantially orthogonal to the docking region of the material handling device.

6. A method (600, 700) in accordance with claim 6, further comprising removing (606, 706) the interface unit from the support device.

7. A method (600, 700) in accordance with claim 7, wherein removing (606, 706) the interface unit from the support device comprises lifting the interface unit at opposed ends in opposition to one another along the longitudinal axis of the interface unit.

8. A method (600, 700) in accordance with claim 8, wherein removing (606, 706) the interface unit from the support device comprises lifting the interface unit with a gantry.

9. A method (700) in accordance with claim 6, further comprising accessing (708) one side of the interface unit, rotating the support device about the axis of rotation passing through the interface unit, accessing (710) the other side of the interface unit, rotating (712) the support device about the axis of rotation passing through the interface unit, and moving (714) the support device to return the interface unit to docking region of the material handling device.
